# EUROPÄISCHE PATENTSCHRIFT

(11) **EP 1 480 426 B1**
(45) Veröffentlichungstag und Bekanntmachung des Hinweises auf die Patenterteilung: **14.07.2010**
(21) Anmeldenummer: 04011755.8
(22) Anmeldetag: 18.05.2004
(51) Int. Cl.: H04M 3/40, H04B 1/74, H03H 7/00

(54) **Unterbrechungsfreie Einstellung von Funktionsgruppen, die Dämpfungsglieder mit festen Werten als Einstellelemente enthalten**
Uninterruptable adjusting of function groups comprising attenuators with fixed values as adjusting elements
Ajustement sans coupure de groupes de fonction comprenant des atténuateurs à valeur fixes comme éléments d'ajustage

(30) Priorität: 23.05.2003 DE 10323780
(43) Veröffentlichungstag der Anmeldung: 24.11.2004
(73) Patentinhaber: Astro Strobel Kommunikationssysteme GmbH, 51427 Bergisch-Gladbach (DE)
(72) Erfinder: Fritscher, Sergej, Dipl.-Ing., 50169 Kerpen (DE); Hartmann, Claus, Dipl.-Ing., 51503 Rösrath (DE); Schmitz, Ralf, Dipl.-Ing., 51069 Köln (DE)
(74) Vertreter: Wolff, Felix

(56) Entgegenhaltungen:
- EP-A- 0 998 032
- DE-B- 1 219 545
- DE-B- 1 280 332

## Beschreibung

Die vorliegende Erfindung betrifft eine Schaltung und ein Verfahren zur Signalübertragung, in der die Signale beim Entfemen von Dämpfungsgliedem mit festen Werten aus einem Zweig der Schaltung durch eine gleichspannungsgesteuerte Stromumschaltung unterbrechungsfrei übertragen werden und die Verwendung der Dämpfungsglieder mit festen Werten als Signalwegumschalter.

Die Integration von Daten-, Audio-, Video- und Telekommunikationsübertragung in einem universellen Netzwerk ist Schwerpunkt des FSN (Full Service Networks). FSN ist eine Infrastruktur für Telekommunikationsanwendungen, die alle heute bekannten Telekommunikationsanwendungen unterstützt und auch den Grundstein für zukünftige Anwendungen legt. Lösungskonzepte für FSN beinhalten vielfältige Übertragungs- und Anschlußformen wie beispielsweise kabellose (wireless) Übertragung, HFC (hybrid fiber / coax) oder FTTC (fiber to the curb). Basis der neuen Entwicklungen sind breitbandige Netzinfrastrukturen wie CATV (Community Antenna Television, Kabelfernsehen), ADSL (Asymmetric Digital Subscriber Line, schneller Internetzugang) oder WLL (Wireless Local Loop, drahtloser Teilnehmeranschluß).

EP 0 998 032 beschreibt eine Verstärkereinrichtung mit eine Bypassleitung.

In Signalverarbeitungsanlagen für TV, Telekommunikation, Audio- oder Videoübertragung wie beispielsweise Verstärkern oder Verteilern, werden zur Frequenzgangkorrektur bzw. Pegeleinstellung (Spannungs-, Leistungs- bzw. Strompegel) _{π}- oder T-Glieder eingesetzt. Diese Glieder müssen entsprechend den Anforderungen der Signalübertragungsanlagen eingestellt sein.

Im Servicefall müssen z. B. zur Zeit verwendbare kontinuierlich einstellbare Dämpfungsglieder vollständig neu eingemessen werden, was zeit- und kostenintensiv ist. Die Verwendung von passiven Dämpfungsgliedern mit festen Werten wie beispielsweise JXP und SXP Attenuators der Firma Communication Associates Inc. (USA, im weiteren "Pads" genannt) oder ähnliche, hat den Vorteil einer erheblich einfacheren Handhabung aber die geeigneten Werte der Dämpfungsglieder in den Geräten müssen eingestellt werden. Beim Austesten der Werte der Dämpfungsglieder wird ein Dämpfungsglied aus dem Sockel gezogen und ein anderes Dämpfungsglied neu gesteckt. Dadurch wird derzeit die Signalübertragung unterbrochen.

Die Aufgabe der Erfindung ist daher eine Schaltung zur Verfügung zu stellen, bei der die Signalübertragung beim Entnehmen oder Stecken von passiven Dämpfungsgliedern mit festen Werten nicht unterbrochen wird, eine vorher definiert eingestellte Übertragung, die das Signal nicht negativ beeinflusst, erhalten bleibt und die Eigenfunktion des passiven Dämpfungsgliedes nach Einstecken in die Schaltung vollständig einwandfrei gewährleistet ist.

Gelöst wird die Aufgabe durch eine Schaltung mit den Merkmalen des Anspruchs 1.

Der Begriff "unterbrechungsfrei" ist im Sinne der vorliegenden Anmeldung durch die Reaktionszeit der aktiven Bauteile definiert. Die Reaktionszeiten liegen üblicherweise im Nanosekunden- bis Millisekundenbereich und sind ohne Beschränkung der Allgemeinheit (o. B. d. A.) vernachlässigbar, weil der Nutzer die dadurch hervorgerufene Unterbrechung des Signals in der Regel nicht wahrnimmt. Unterbrechungsfrei heißt also, dass die Signalübertragung unter Vernachlässigung der Schaltzeiten von aktiven Komponenten unterbrechungsfrei erfolgt.

Als passive Komponente wird in der Schaltung vorzugsweise ein Dämpfungsglied mit festen Werten eingesetzt und zwar vorzugsweise ein Dämpfungsglied mit 3 Kontakten, die einen Eingang, einen Ausgang und vorzugsweise mindestens ein Querglied zur Masse und zwar vorzugsweise über ein Entkoppelglied, enthalten. Das Entkoppelglied kann auch ein Kurzschluß sein.

Die Schaltung ist ebenfalls funktionsfähig, wenn als passive Komponente eine 0-Brücke eingesetzt wird, beispielsweise in Form eines 2-poligen AC-Jumpers.

Ein weiterer Gegenstand der vorliegenden Erfindung ist eine Parallelschaltung, die in einem Zweig ein vorzugsweise passives 3-poliges Dämpfungsglied mit festen Werten aufweist und in der beim Entfernen des vorzugsweise passiven 3-poligen Dämpfungsgliedes mit festen Werten die Signalübertragung über den anderen Zweig der Schaltung gleichspannungsgesteuert unterbrechungsfrei ist.

Die folgenden Ausführungen gelten für beide erfindungsgemäßen Schaltungen.

Vorzugsweise werden JXP oder SXP Attenuators beispielsweise die der Firma Communication Associates Inc. (Pads) als Dämpfungsglieder eingesetzt.

Vorzugsweise ist der für die Gleichspannungssteuerung notwendige Gleichstrom dem Signal überlagert, wenn er in den Zweig einfließt, der das Dämpfungsglied enthält. Der Gleichstrom fließt, wenn das Dämpfungsglied nicht gesteckt ist, in dem anderen Zweig der Schaltung und ist auch dort dem Signal überlagert. Die Schaltung kann so dimensioniert werden, dass immer nur ein Zweig der Schaltung stromdurchflossen ist. Diese gleichspannungsgesteuerte Stromwegumschaltung gewährleistet, dass durch den ersten Stromweg keine Beeinflussung des Signals erfolgt, wenn das passive Dämpfungsglied in der Schaltung gesteckt ist und das Signal über den zweiten Stromweg geführt wird. Durch die Umschaltung des Signalweges ist also die vollständige einwandfreie Eigenfunktion des passiven Dämpfungsgliedes sichergestellt, wenn dieses in die Schaltungen eingesteckt ist.

Vorzugsweise werden als Dämpfungsglieder passive Dämpfungsglieder wie _{π}- oder T-Glieder eingesetzt. Diese ermöglichen, dass in Signalrichtung ein Gleichstrom fließen kann.

Das Dämpfungsglied in der Schaltung wird vorzugsweise als Komponente zur Spannungs-, Leistungs- oder Strompegeleinstellung oder zur Frequenzgangeinstellung eines beliebigen elektrischen Signals verwendet. Dies sind die Standardfunktionen der Dämpfungsglieder, die eingestellt werden müssen.

Die Schaltung eignet sich zur Übertragung eines vorzugsweise hochfrequenten (HF-) Signals, wobei der Gleichstrom, der dem Signal überlagert ist, vorzugsweise durch eine Außenbeschaltung ein- bzw. ausgekoppelt ist.

Der Fachmann erkennt, dass die Einkopplung des Gleichstroms sowohl außerhalb als auch innerhalb der Zweige der Parallelschaltung erfolgen kann in Abhängigkeit von der Beschaltung. Dies gilt auch für die Auskopplung des Gleichstroms. In einer bevorzugten Ausführungsform der Schaltung wird der Gleichstrom in die eine aktive Komponente des ersten Stromweges und/oder in einer weiteren aktive Komponente des ersten Stromweges eingekoppelt.

In den ersten Stromweg der Schaltung hinter die mindestens eine aktive Komponente sind vorzugsweise passive Komponenten (Zusatzglied) einfügbar. Wenn das Dämpfungsglied D nicht gesteckt ist, dämpfen die passiven Komponenten die Signalübertragung vorzugsweise definiert, so dass eine vorher definierte Übertragung des Signals gewährleistet ist. In einer bevorzugten Ausführungsform sind die passiven Komponenten so abgestimmt, dass die Übertragung wellenwiderstandsgerecht erfolgt, auch wenn das passive Dämfungsglied entfernt ist und der aktive Stromweg der erste Stromweg durch die passive Komponente ist. Der Wellenwiderstand beträgt beispielsweise 75_{Ω} oder 50_{Ω}. Somit treten auch in diesem Funktionszustand der Schaltung keine Reflektionen auf, die das übertragene Signal negativ beeinflussen.

Vorzugsweise wird die Schaltung in Geräten eingesetzt, die Teil eines FSN (Full Service Networks) sind und zwar vorzugsweise in Verteilern, Abzweigem, Zusammenführungsnetzwerken oder Verstärkern für Audio- oder Video- oder Telekommunikationsübertragung, z. B. CATV-Anlagen oder ADSL-Anlagen. Sie ist vorzugsweise sowohl für elektrische Signalübertragung geeignet, als auch in elektrisch/optischen Schnittstellen einer optischen Signalübertragung.

Vorteilhafterweise ermöglicht die Schaltung eine unterbrechungsfreie Übertragung eines vorzugsweise hochfrequenten Signals beim Stecken oder Entfernen eines passiven Dämpfungsgliedes mit festen Werten. Dabei bleibt eine vorher definierte Übertragung erhalten, wenn das Dämpfungsglied entfernt ist, die das Signal nicht negativ beeinflusst.

Ein weiterer Gegenstand der vorliegenden Erfindung ist ein Verfahren, dass die Einstellung der Dämpfung in einer Schaltung mit 3-poligen Dämpfungsgliedem mit festen Werten ermöglicht und bei dem ein 3- poliges Dämpfungsglied aus einem zweiten Stromweg entfernt wird und bei dem durch das Entfernen des Dämpfungsgliedes ein Signal unterbrechungsfrei gleichspannungsgesteuert über einen ersten Stromweg übertragen wird. Dabei wird in dem Verfahren der für die Gleichspannungssteuerung notwendige Gleichstrom dem Signal überlagert, wenn er in den zweiten Stromweg fließt, der das Dämpfungsglied enthält.

Da die Einstellung der Dämpfung nur durch Stecken und Entfernen von 3-poligen Dämpfungsgliedern mit festen Werten erfolgt, wobei die Dämpfung oder Entzerrung der Dämpfungsglieder variabel gewählt wird, ist die Durchführung des Einstellvorganges im Servicefall sehr einfach.

In einer bevorzugten Ausführungsform des Verfahrens wird in dem ersten Stromweg eine definierte Dämpfung des übertragenen Signals verursacht, wenn das passive Dämpfungsglied mit festen Werten aus dem zweiten Stromweg entfernt ist. Um Reflektionen zu vermeiden, die die Signalübertragung negativ beeinflussen, erfolgt die Signalübertragung in dem Verfahren vorzugsweise wellenwiderstandsgerecht.

Ein weiterer Gegenstand der vorliegenden Erfindung ist die Verwendung der 3-poligen Dämpfungsglieder mit festen Werten als elektrische Signalwegumschalter. In einer anderen bevorzugten Ausführungsform werden die 3-poligen Dämpfungsglieder als mechanische Signalwegumschalter verwendet. Vorzugsweise schalten sie einen Stromweg in einen anderen Stromweg um. Vorzugsweise erfolgt die Stromwegumschaltung duch Verwendung von mindestens einer aktiven Komponente in einem der beiden Stromwege. Dazu werden die eine oder mehrere aktive Komponenten des ersten Stromweges eingesetzt. Wenn das Dämpfungsglied als elektrischer Signalwegumschalter verwendet wird, werden vorzugsweise keine weiteren Schaltkontakte als die 3 Kontakte der Dämpfungsglieder benötigt, damit Standardbauelemente wie beispielsweise Pads eingesetzt werden können.

Da die Verwendung von Standardbauelemente möglich ist und keine weiteren Schaltkontakte benötigt werden, ist die Verwendung der 3-poligen Dämpfungsglieder mit festen Werten, z. B. Pads kostengünstig und sehr einfach.

Im folgenden wird die Erfindung anhand der **Figuren 1 - 9** erläutert. Diese Erläuterungen sind lediglich beispielhaft und schränken den allgemeinen Erfindungsgedanken nicht ein.
- **Figur 1**: zeigt ein vereinfachtes schematisches Blockschaltbild der erfindungsgemäßen Schaltung sowie beispielhaft die Ein- und Auskopplung des Gleichstroms
- **Figur 2**: zeigt eine schematische Darstellung eines 3-poligen Dämpfungsgliedes
- **Figur 3**: zeigt ein _{π}-Glied eines 3-poligen Dämpfungsgliedes
- **Figur 4**: zeigt ein T-Glied eines 3-poligen Dämpfungsgliedes
- **Figur 5**: zeigt ein Blockschaltbild einer möglichen Ausführungsform der erfindungsgemäßen Schaltung
- **Figur 6**: zeigt ein Blockschaltbild einer anderen möglichen Ausführungsform der erfindungsgemäßen Schaltung
- **Figur 7**: zeigt eine mögliche Ausführung der erfindungsgemäßen Schaltung
- **Figur 8**: zeigt eine mögliche Ausführung der erfindungsgemäßen Schaltung
- **Figur 9**: zeigt eine mögliche Ausführung der erfindungsgemäßen Schaltung

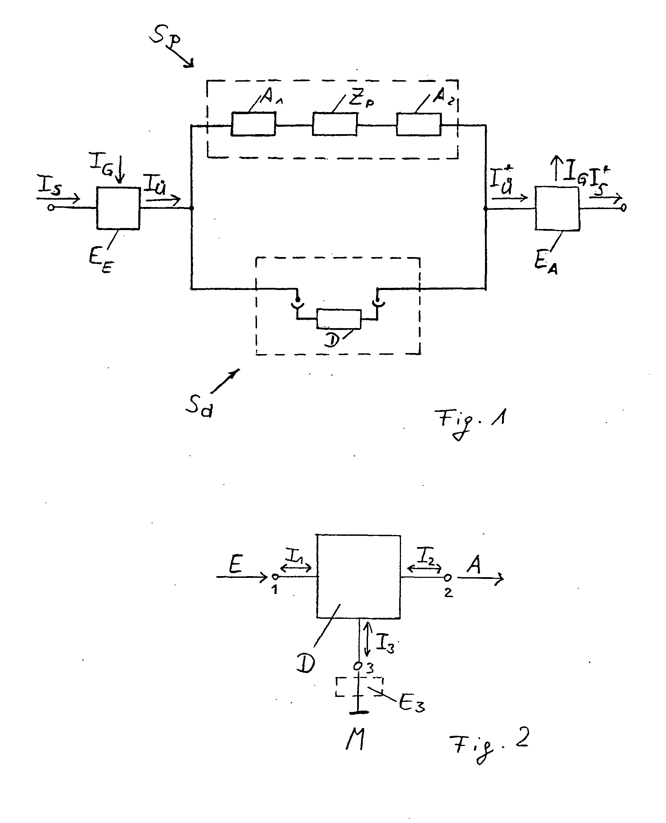

In **Figur 1** ist vereinfacht schematisch die erfindungsgemäße Schaltung sowie die Ein- und Auskopplung E_{E} bzw. E_{A} des Gleichstroms I_{G} in der Außenbeschaltung dargestellt.
Die Schaltung ist eine Parallelschaltung von einem ersten Stromweg Sₚ und einem zweiten Stromweg S_{d}. Im ersten Stromweg Sₚ befindet sich mindestens ein aktives Bauelement A₁. In Reihe mit dem einen aktiven Bauelement A₁ kann mindestens ein passives Bauelement Zₚ sowie weitere aktive Bauelemente A₂ geschaltet sein. Im zweiten Stromweg S_{d} befindet sich nur ein Dämpfungsglied D, das reversibel in den Zweig ein- und ausgesteckt werden kann. Die erfindungsgemäße Schaltung wird durch einen Strom I_{Ü} durchflossen, der sich aus einem Signal I_{S} und einem Gleichstrom I_{G} zusammensetzt. Der Gleichstrom I_{G} wird durch eine Außenbeschaltung E_{E} eingekoppelt und durch eine Außenbeschaltung E_{A} ausgekoppelt.

In der folgenden Erläuterung seien ohne Beschränkung der Allgemeinheit (o. B. d. A.) A₂ und Zₚ Kurzschlüsse.
Das mindestens eine aktive Bauteil A₁ im ersten Stromweg Sₚ kann beispielsweise eine Diode sein, die den Stromfluss und damit die Übertragung des Signals I_{S} nur zulässt, wenn an ihr die von ihr mindestens benötigte Schaltspannung anliegt. Die Schaltung wird dann vorzugsweise so dimensioniert, dass das der Fall ist, wenn das Dämpfungsglied D im zweiten Stromweg S_{d} entfernt ist. Ist das Dämpfungsglied D eingesteckt, so wird mindestens ein Teil des Stromes I_{Ü} durch das Dämpfungsglied D fließen. Ist die Schaltung richtig dimensioniert, fällt dann nicht mehr genug Spannung über dem aktiven Bauteil A₁, z. B. der Diode, ab, damit sie durchschalten und von einem Strom durchflossen werden kann, so dass dann der gesamte Strom I_{Ü} durch das Dämpfungsglied D fließt. Der erste Stromweg Sₚ ist dann für das Signal I_{S} gesperrt und damit ist die vollständige einwandfreie Funktion des Dämpfungsglieds D sichergestellt. Somit fließt der Strom I_{Ü} entweder im ersten Stromweg Sₚ, wenn das Dämpfungsglied D nicht eingesteckt ist oder der Strom fließt im zweiten Stromweg S_{d}, wenn das Dämpfungsglied D eingesteckt ist. Die Umschaltung erfolgt also gleichspannungsgesteuert, wobei der Gleichstrom I_{G}, der dem Signal I_{S} überlagert ist, als Steuerstrom dient.
Somit ist sichergestellt, dass das Signal I_{S} unterbrechungsfrei übertragen wird und es wird immer eine definierte Dämpfung bei der Übertragung gewährleistet.
Wird beispielsweise ein Verstärker für ein TV-Signal im Servicefall eingestellt, wird die Übertragung des Signals beim Einstellen der Dämpfungsglieder im Verstärker weiterhin gewährleistet.

In **Figur 2** ist schematisch ein 3-poliges Dämpfungsglied D dargestellt.
Ein Signal wird durch den Eingang E in das Dämpfungsglied D geführt, gedämpft und zum Ausgang A geführt. Der dritte Pol des Dämpfungsgliedes D kann über eine Entkoppelschaltung E₃ zur Masse M führen. Ohne Beschränkung der Allgemeinheit (o. B. d. A.) kann E₃ auch ein Kurzschluß sein.

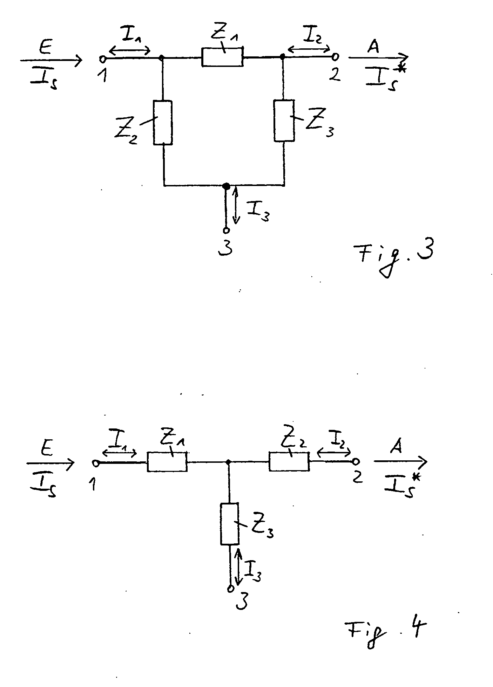

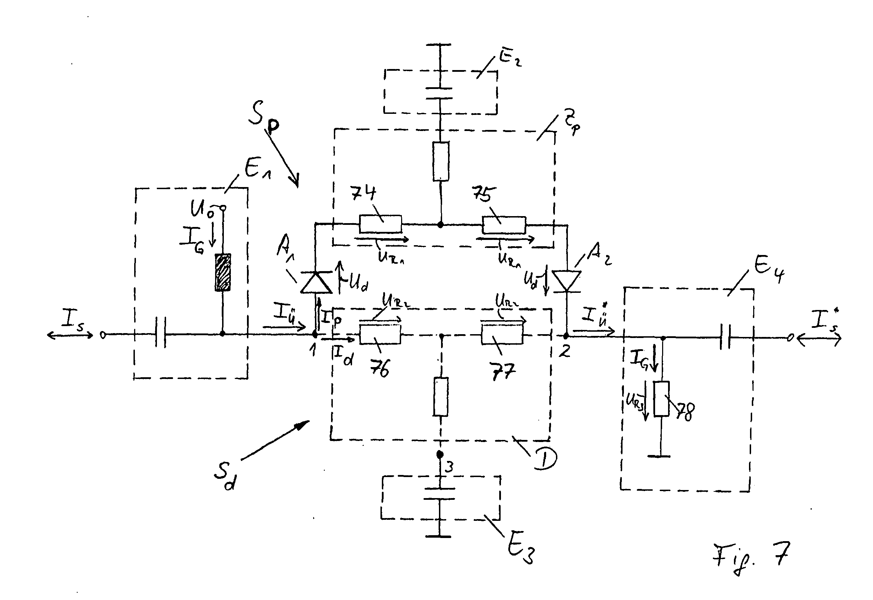

**Figur 3** zeigt ein _{π}-Glied eines 3-poligen Dämpfungsgliedes, **Figur 4** ein T-Glied. Die hier eingesetzten Dämpfungsglieder mit festen Werten werden möglichst so aufgebaut, dass der komplexe Widerstand Z₁ in **Figur 3** bzw. Z₁ und Z₂ in **Figur 4** immer gleichstromdurchlässig sind und die komplexen Widerstände Z₂ und Z₃ in **Figur 3** sowie Z₃ in **Figur 4** auch nicht vorhanden sein können. Dies wird in den **Figuren 7****,** **8** und **9** verdeutlicht.

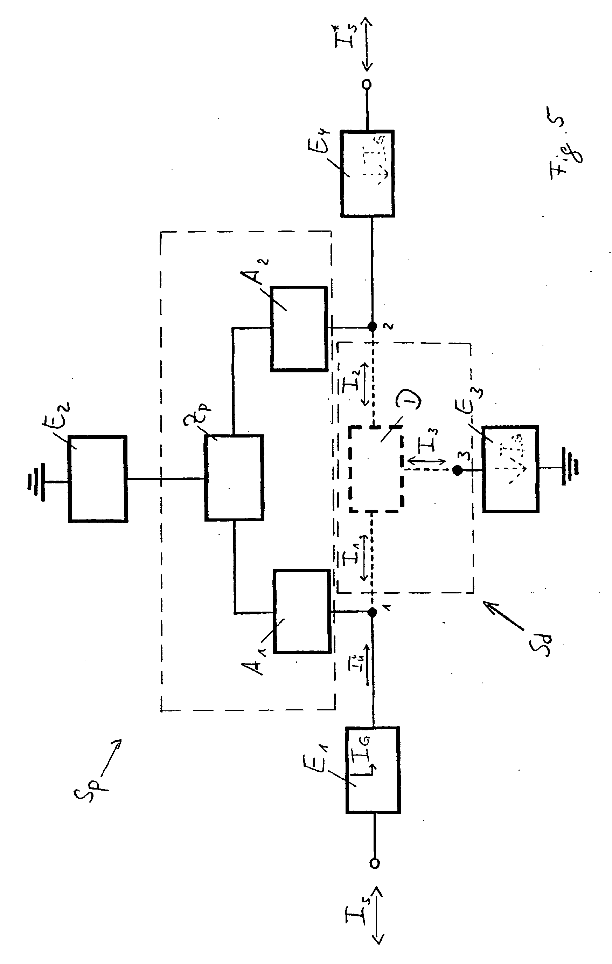

**Figur 5** stellt ein Blockschaltbild einer möglichen Ausführungsform der erfindungsgemäßen Schaltung dar. Die Einspeisung des hochfrequenten (HF-) Signals I_{S} kann grundsätzlich von beiden Seiten aus erfolgen. In Abhängigkeit von der Beschaltung zur Einspeisung des Gleichstroms I_{G} kann dieser an geeigneten Stellen E₁ - E₄ zu- bzw. abgeführt werden, daher ist er hier in E₃ und E₄ beispielhaft gestrichelt dargestellt. Außerdem dienen die Schaltungen E₁ - E₄ zur Entkopplung. A₁ und A₂ sind aktive Komponenten oder Schaltungen, die beispielsweise mehrere Dioden, Transistoren oder Relais sein können, über die auch der Steuerstrom eingespeist sein könnte. Zₚ ist eine Schaltungskomponente, die eine definierte Dämpfung oder Kurzschluss herstellt, wenn das Dämpfungsglied D nicht eingesteckt ist.
Ist das Dämpfungsglied D im zweiten Stromweg S_{d} eingesteckt, dann sind die aktive Komponente A₁ und die weiteren Komponenten des ersten Stromweges Sₚ so eingestellt, dass das übertragene Signal I_{S} sowie der Gleichstrom in das Dämpfungsglied im zweiten Stromweg S_{d} fließt, womit die vollständige und einwandfreie Funktion des Dämpfungsgliedes D sichergestellt ist.
Wird das Dämpfungsglied D aus dem zweiten Stromweg S_{d} entfernt, dann fließt das Signal und der Gleichstrom unterbrechungsfrei durch den ersten Stromweg Sₚ. Die Dämpfung wird dann durch die Dämpfung des Zusatzgliedes Zₚ vorzugsweise wellenwiderstandsgerecht sichergestellt.

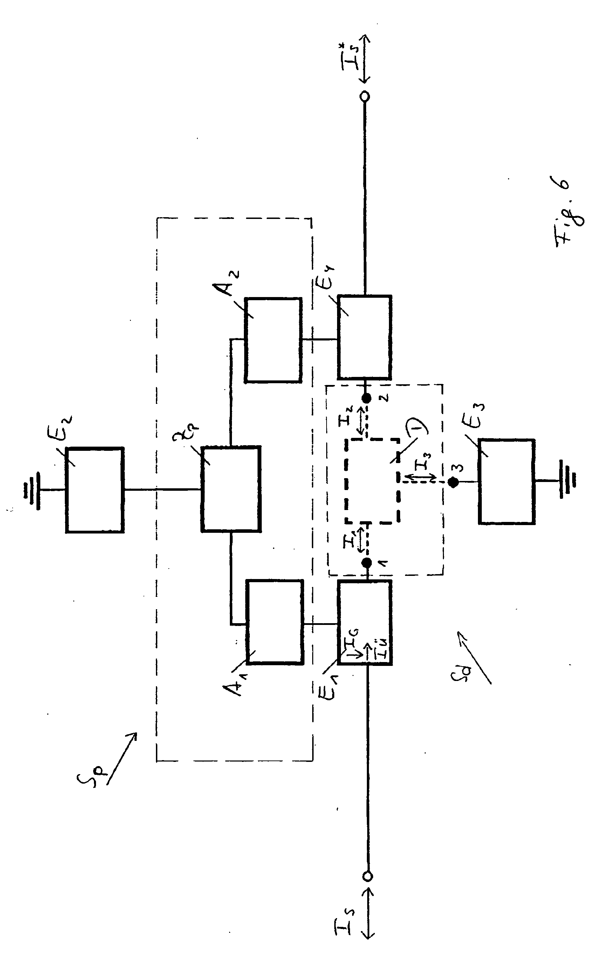

**Figur 6** stellt ein Blockschaltbild einer möglichen Ausführungsform der erfindungsgemäßen Schaltung dar. **Figur 5** und **Figur 6** unterscheiden sich darin, an welchen Stellen der Gleichstrom I_{G} in den ersten Stromweg Sₚ eingekoppelt bzw. abgeführt wird. Ansonsten kann die Schaltung analog zur Schaltung in **Figur 5** betrachtet werden.

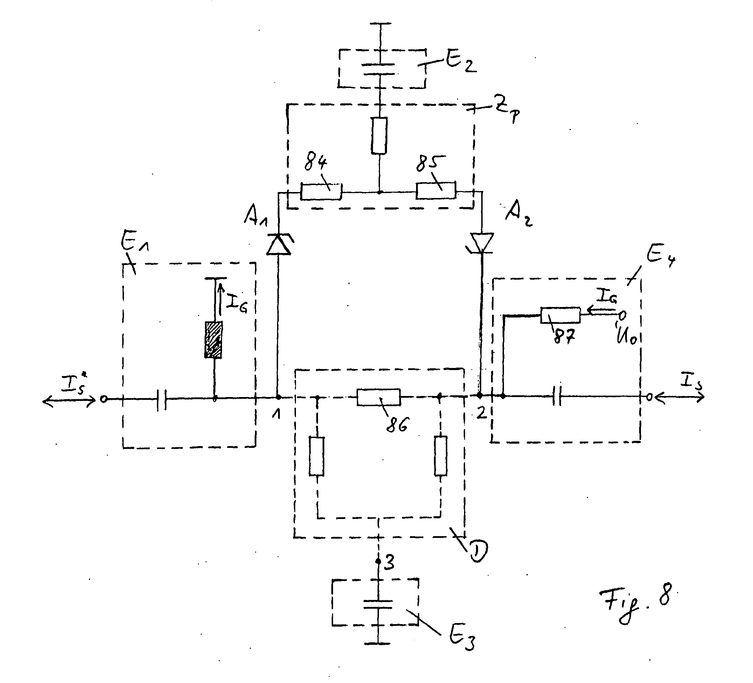

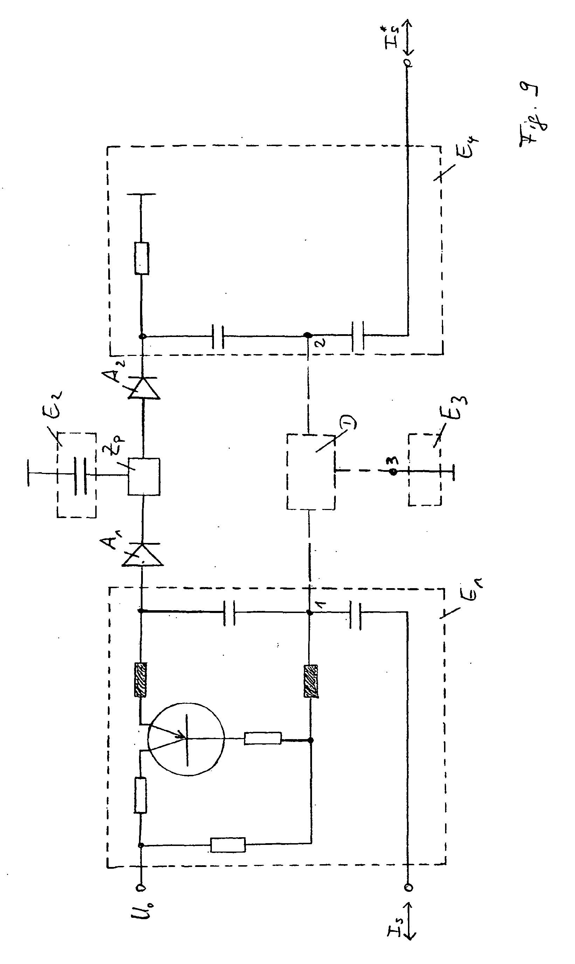

**Figur 7****,** **Figur 8** sowie **Figur 9** zeigen mögliche Ausführungsformen der erfindungsgemäßen Schaltung wobei die **Figuren 7** und **8** die Ein- und Auskopplung des steuernden Gleichstrom I_{G} entsprechend dem Blockschaltbild in **Figur 5** zeigen und **Figur 9** eine mögliche Ein- und Auskopplung des steuernden Gleichstroms I_{G} entsprechend dem Blockschaltbild in **Figur 6****,** wobei überall die Ein- bzw. Ausgänge vertauscht sein können.

In **Figur 7** wird der steuernde Gleichstrom I_{G} in der Komponente E₁ zugeführt. Die über der Induktivität in E₁ abfallende Spannung sei vernachlässigbar. U₀ ist die Spannung zur Masse. Die aktiven Komponenten A₁, A₂ des ersten Stromweges Sₚ sind zwei o. B. d. A. gleich große Dioden, an denen eine Spannung U_{D} in Richtung des Stromes abfällt. Die Zusatzkomponente Zₚ hat die Form eines T-Gliedes, wobei die komplexen Widerstände 74, 75 im Längszweig o. B. d. A. zwei gleich große ohmsche Widerstände sind, an denen jeweils die Spannung U_{R1} abfällt. Der Gleichstrom I_{G} wird in E₄ über einen komplexen Widerstand 78 abgeführt, der o. B. d. A. ein ohmscher Widerstand ist, über den die Spannung U_{R3} abfällt und der den Strom begrenzt. Im zweiten Stromweg S_{d} ist das Dämpfungsglied D ebenfalls ein T-Glied, wobei die komplexen Widerstände im Längszweig 76, 77 o. B. d. A. ohmsche Widerstände sind, über die die Spannung U_{R2} abfällt. Sowohl im ersten wie auch im zweiten Stromweg S_{d} ist die Summe der anfallenden Spannungen gleich der Versorgungsspannung abzüglich der über dem komplexen Widerstand 78 abfallenden Spannung U_{R3}. Der Übertragungsstrom I_{Ü}, der sich aus dem Signal I_{S} und dem Gleichstrom I_{G} zusammensetzt, teilt sich in der Parallelschaltung in einen Strom Iₚ, der im ersten Stromweg Sₚ fließt und in einen Strom I_{d}, der im zweiten Stromweg S_{d} fließt. Die zu erfüllende Schaltbedingung ist, dass bei eingestecktem Dämpfungsglied D der gesamte Strom I_{Ü} über den zweiten Stromweg S_{d} fließt, also der Strom im ersten Stromweg Iₚ Null ist, während bei gezogenem Dämpfungsglied D der gesamte Strom I_{Ü} über den ersten Stromweg Iₚ fließt. Mit diesen Bedingungen können die Widerstände und Dioden so dimensioniert werden, das die Schaltbedingung erfüllt ist. Die Anpassung des Wellenwiderstandes in den Schaltzuständen gestecktes und gezogenes Dämpfungsglied erfolgt über die Dimensionierung des Querzweiges (entsprechend dem Zweig entlang des Signalweges I_{S} - I_{S}*) des Dämpfungsglieds D und im Zusatzglied Zₚ, wobei die Glieder D bzw. Zₚ auch o. B. d. A. Kurzschlüsse sein können.

Mit Zₚ kann der Wellenwiderstand der Schaltung so eingestellt werden, das sie sich wellenwiderstandsgerecht verhält, wenn das Dämpfungsglied D nicht eingesteckt ist. Über A₁, A₂ und Zₚ fällt die Schwellspannung ab, die bei eingestecktem Dämpfungsglied D unterschritten werden muss, damit der überlagerte Strom I_{Ü}, der sich aus dem Signalstrom I_{S} und dem überlagerten Gleichstrom I_{G} zusammensetzt, vollständig durch das Dämpfungsglied D fließt. Der Gleichstrom I_{G}, der als Steuerstrom genutzt wird und in dem Dämpfungsglied D die Schaltspannung erzeugt, durchfließt dann immer mindestens zwei der Stromwege I₁ - I₃ (s. **Figuren 2 - 6****).** Unter der Vorraussetzung, dass ein _{π}-Glied oder ein T-Glied wie in **Figur 3** und in **Figur 4** beschrieben genutzt wird, in denen die zur Masse zeigenden Komponenten gleichstromundurchlässig sind, können z. B. die Ströme I₁ und I₂ vom Gleichstrom I_{G} genutzt werden. Der übertragene Teil des HF-Signals I_{S} fließt dann auch über I₁ und I₂. Das heißt, das der steuernde Gleichstrom I_{G} den gleichen Weg nutzt, wie das HF-Signal I_{S}, das übertragen wird. Die Gleichströme I₁ - I₃ können dabei je nach Einkoppelstelle in die eine oder in die andere Richtung fließen.

In **Figur 8** ist als Variante das Dämpfungsglied D ein _{π}-Glied. Die aktiven Komponenten sind als Zenerdioden ausgeführt. Dementsprechend ist im Dämpfungsglied D nur ein komplexer Widerstand 86, der o. B. d. A. ein ohmscher Widerstand sein kann, für die Schaltspannung verantwortlich. Die Schaltung lässt sich analog zur Schaltung in **Figur 7** dimensionieren.

Ein Gegenstand der vorliegenden Erfindung ist, dass das Dämpfungsglied D als Schaltelement genutzt wird und keine weiteren Schaltkontakte benötigt werden, damit Bauelemente wie beispielsweise Pads der Firma Communication Associates Inc. eingesetzt werden können.
Unter der Annahme, dass in die Zusatzkomponente Zₚ eine definierte Dämpfung, die o. B. d. A. auch gleich Null sein kann, eingebaut wird und wenn sicher gestellt sein soll, dass die Dämpfungsglieder, die in die Schaltung eingesteckt werden, eine Dämpfung z. B. im Bereich von 0 - 20dB annehmen können, kann der steuernde Gleichstrom I_{G} nur in E₁ bzw. E₄ ein- bzw. ausgekoppelt sein. Nur wenn manche Dämpfungswerte, abhängig von dem Dämpfungsbereich, der eingestellt werden soll, ausgeschlossen werden können, z. B. 0dB Dämpfung, d. h. Kurzschluss zwischen den Punkten 1 und 2 und Leerlauf zu Pin 3, kann es sinnvoll und möglich sein, den steuernden Gleichstrom I_{G} z. B. in E₃ auszukoppeln. (Daher ist in **Figur 5** I_{G} in E₃ und E₄ gestrichelt dargestellt.)

Ein Beispiel dafür, den Gleichstrom I_{G} in E₃ auszukoppeln ist in **Figur 9** dargestellt. **Figur 9** entspricht vom Aufbau dem Blockschaltbild in **Figur 6****.**

In **Figur 9** wird der Gleichstrom in E₁ erzeugt und fließt in E₃ ab, wenn das Dämpfungsglied D gesteckt ist und in E₄, wenn das Dämpfungsglied nicht gesteckt ist. E₂ entkoppelt den Gleichstrom von der Masse, die Zₚ benötigt. Mit Zₚ wird der Wellenwiderstand der Schaltung wellenwiderstandsgerecht eingestellt, wenn das Dämpfungsglied nicht gesteckt sind. A₁ und A₂ sind die aktiven Komponenten, deren Schaltspannung gleich oder überschritten werden muß, damit der Strom durch sie fließen kann.
Als Dämpfungsglied D darf in dieser Schaltung kein Dämpfungsglied verwendet werden, in dem der Kontakt 3 nicht belegt ist, da in dieser Schaltung der Gleichstrom I_{G} über E₃ abfließt, wenn das Dämpfungsglied D gesteckt ist. Es können hier also nur Dämpfungsglieder eingesetzt werden, die im Querzweig gleichstromdurchlässig sind. Beispielsweise die Dämpfung 0dB kann mit dieser Schaltung nicht realisiert werden. Wenn diese Dämpfungen ausgeschlossen werden, kann das Dämpfungsglied D als Schalter eingesetzt werden, und benötigt keine weiteren Schaltkontakte im oder am Dämpfungsglied.

### Verwendete Abkürzungen:

- S_{d}: Stromweg, wenn das Dämpfungsglied D eingesteckt ist und der das Dämpfungsglied D enthält.
- Sₚ: Stromweg, wenn das Dämpfungsglied D nicht eingesteckt ist.
- I_{S}: hochfrequentes Signal, das übertragen werden soll und von beiden Seiten aus in die Schaltung fließen kann.
- I_{S}*: hochfrequentes Signal, nachdem es die Schaltung durchlaufen hat, abhängig vom Dämpfungsglied können I_{S} und I_{S}* gleich sein
- I_{G}: Gleichstrom, der dem Signal überlagert wird.
- I_{Ü}: Summenstrom aus dem Signal und dem überlagerten Gleichstrom
- I_{Ü}*: Summenstrom, nachdem er die Schaltung durchlaufen hat, abhängig vom Dämpfungsglied kann I_{Ü} und I_{Ü}* gleich sein
- I_{d}: Strom im Stromweg S_{d}
- Iₚ: Strom im Stromweg Sₚ
- D: Dämpfungsglied, z. B. ein _{π}-Glied oder ein T-Glied mit festen Dämpfungswerten, z. B. Pads der Firma Communication Assotiates (JXP bzw. SXP Attenuators o. ä.). Das Dämpfungsglied selbst erzeugt die Schaltspannung durch den durch seine Bausteine fließenden Strom.
- E_{E}, E_{A}: Ein- bzw. Auskopplung des Gleichstroms I_{G}
- A₁, A₂: Aktive Komponenten oder Schaltungen, wobei eine der beiden ganz entfallen kann. Die Komponenten können eine oder mehrere Dioden, Transistoren oder Relais sein.
- Zₚ: Zusatzglied, z. B. ein _{π}-Glied oder ein T-Glied, zum Herstellen eines definierten Zustandes, z. B. eine Dämpfung von 0dB (Kurzschluß) oder eine Dämpfung von 6dB etc.. Das Zusatzglied passt die Schaltung an den Wellenwiderstand der äußeren Beschaltung an, wenn das Dämpfungsglied D nicht gesteckt ist. Eine weitere Funktion ist der Anteil, den das Zusatzglied zur Schwellenspannung beiträgt.
- Z₁ - Z₃: komplexe Widerstände, die einen ohmschen Widerstand, eine Induktivität und eine Kapazität beinhalten und der Gleichung Zᵢ = R + j(_{ω}L-1/_{ω}C) folgen.
- E₁ - E₄: Ein-, Aus- oder Entkoppelschaltungen, wobei E₂ und E₃ auch Kurzschlüsse oder Koppelkondensatoren sein können.
- U_{R1}, U_{R2}, U_{R3}, U_{D}: Spannungen, die über den Bauelementen abfallen
- E: Signal - Eingang
- A: Signal - Ausgang
- M: Masse

## Patentansprüche

1. Schaltung zur unterbrechungsfreien Signalübertragung eines Signals (I_{S}), die einen ersten Stromweg (Sₚ) und einen zweiten Stromweg (S_{d}), die parallel geschaltet sind, aufweist, in der der erste Stromweg (Sₚ) mindestens ein aktives Bauteil (A₁, A₂) enthält und in der der zweite Stromweg (S_{d}) zumindest zeitweise eine passive Komponente (D), die reversibel einsteckbar ist, aufweist, **dadurch gekennzeichnet, dass** die Schaltung und zumindest das eine aktive Bauteil (A₁, A₂) so dimensioniert sind, dass eine gleichspannungsgesteuerte Durchschaltung des ersten Stromwegs (Sₚ) mittels des aktiven Bauteils (A₁, A₂) vorgesehen ist, wenn der zweite Stromweg (S_{d}) die passive Komponente (D) nicht enthält, und dass eine gleichspannungsgesteuerte Abschaltung des ersten Stromwegs (Sₚ) mittels des aktiven Bauteils (A₁, A₂) vorgesehen ist, wenn der zweite Stromweg (S_{d}) die passive Komponente (D) enthält, wobei zum Schalten des aktiven Bauteils (A₁, A₂) ein Steuerstrom vorgesehen ist, welcher als Gleichstrom (I_{G}) dem Signal (Iₛ) überlagert ist.

2. Schaltung nach Anspruch 1 **dadurch gekennzeichnet, dass** die passive Komponente (D) ein passives Dämpfungsglied mit festen Werten ist.

3. Schaltung nach einem der vorherigen Ansprüche **dadurch gekennzeichnet, dass** das Dämpfungsglied (D) 3 Kontakte besitzt, die einen Eingang (E), einen Ausgang (A) und mindestens ein Querglied enthalten, das über eine Entkoppelschaltung (E₃) zur Masse (M) geführt ist.

4. Schaltung nach einem der vorherigen Ansprüche **dadurch gekennzeichnet, dass** als Dämpfungsglieder (D) JXP oder SXP Attenuators verwendetwerden.

5. Schaltung nach Anspruch 1, **dadurch gekennzeichnet, dass** das Dämpfungsglied (D) ein 3-poliges passives Dämpfungsglied mit festen Werten (D) umfasst und dass beim Entfernen des 3-poligen Dämpfungsgliedes mit festen Werten die Signalübertragung gleichspannungsgesteuert unterbrechungsfrei über den ersten Stromweg (Sₚ) ist.

6. Schaltung nach einem der vorherigen Ansprüche **dadurch gekennzeichnet, dass** das Dämpfungsglied (D) ein π- oder ein T-Glied ist.

7. Schaltung nach einem der vorherigen Ansprüche **dadurch gekennzeichnet, dass** das Dämpfungsglied (D) eine Komponente zur Spannungs-, Leistungs- oder Strompegeleinstellung oder zur Frequenzgangeinstellung eines beliebigen elektrischen Signals ist.

8. Schaltung nach einem der vorherigen Ansprüche **dadurch gekennzeichnet, dass** sie zur (hochfrequenten) Signalübertragung geeignet ist.

9. Schaltung nach einem der vorherigen Ansprüche **dadurch gekennzeichnet, dass** der in der Schaltung überlagerte Gleichstrom (I_{G}) durch eine Beschaltung (E_{E}) eingekoppelt und durch eine weitere Beschaltung (E_{A}) ausgekoppelt ist.

10. Schaltung nach einem der vorherigen Ansprüche **dadurch gekennzeichnet, dass** der Gleichstrom (I_{G}) in der einen aktiven Komponente (A₁) und / oder einer weiteren aktiven Komponente (A₂) des ersten Stromweges (Sₚ) eingekoppelt ist.

11. Schaltung nach einem der vorherigen Ansprüche **dadurch gekennzeichnet, dass** in den ersten Stromweg (Sₚ) passive Komponenten (Zₚ) hinter die mindestens eine aktive Komponente (A₁) geschaltet sind.

12. Schaltung nach Anspruch 1 **dadurch gekennzeichnet, dass** die passiven Komponenten (Zₚ) im ersten Stromweg (Sₚ) in Bezug auf die Signalübertragung eine definierte Dämpfung verursachen.

13. Schaltung nach einem der vorherigen Ansprüche **dadurch gekennzeichnet, dass** sie wellenwiderstandsgerecht aufgebaut werden kann.

14. Schaltung nach einem der vorherigen Ansprüche **dadurch gekennzeichnet, dass** die Schaltung in Geräten eingesetzt wird, die Teil eines FSN (Full Service Networks) sind.

15. Schaltung nach Anspruch 14 **dadurch gekennzeichnet, dass** die Geräte des Full Service Networks Verteiler oder Abzweiger oder Zusammenführungsnetzwerke oder Verstärker für Audio- oder Video- oder Telekommunikationsübertragung, z. B. CATV-Anlagen oder ADSL-Anlagen sind.

16. Schaltung nach einem der vorherigen Ansprüche **dadurch gekennzeichnet, dass** sie sich sowohl für elektrische Signalübertragung als auch in elektrisch/optischen Schnittstellen einer optischen Signalübertragung eignet.

17. Verfahren zur Einstellung der Dämpfung von Schaltungen mit 3-poligen Dämpfungsgliedem (D) mit festen Werten, bei dem das Dämpfungsglied (D) zeitweise aus einem zweiten Stromweg (S_{d}) entfernt wird und bei dem durch das Entfernen des Dämpfungsgliedes (D) ein Signal (I_{S}) unterbrechungsfrei gleichspannungsgesteuert über einen ersten Stromweg (Sₚ) übertragen wird,
**dadurch gekennzeichnet, dass** der für die Gleichspannungssteuerung notwendige Gleichstrom (I_{G}) dem Signal (I_{S}) überlagert ist, wenn er in den zweiten Stromweg (S_{d}) einfließt.

18. Verfahren nach Anspruch 17 **dadurch gekennzeichnet, dass** der erste Stromweg (Sₚ) eine definierte Dämpfung des übertragenen Signals (I_{S}) verursacht, wenn das passive Dämpfungsglied (D) aus dem zweiten Stromweg (S_{d}) entfernt ist.

19. Verfahren nach einem der Ansprüche 17 bis 18 **dadurch gekennzeichnet, dass** die Signalübertragung wellenwiderstandsgerecht erfolgt.

20. Verwendung von 3-poligen Dämpfungsgliedem mit festen Werten als elektrische Signalwegumschalter in einer Schaltung gemäß einem der Ansprüche 13 bis 16.

21. Verwendung von 3-poligen Dämpfungsgliedern mit festen Werten als mechanische Signalwegumschalter in einer Schaltung gemäß einer der Ansprüche 13 bis 16.

22. Verwendung nach einem der Ansprüche 20 oder 21 **dadurch gekennzeichnet, dass** die 3-poligen Dämpfungsglieder mit festen Werten zum Umschalten eines Stromweges in einen anderen Stromweg eingesetzt werden.

23. Verwendung nach Anspruch 22 **dadurch gekennzeichnet, dass** die Stromwegumschaltung durch Verwendung von mindestens einer aktiven Komponente in einem der beiden Stromwege erfolgt.

24. Verwendung nach einem der Ansprüche 20 oder 22 **dadurch gekennzeichnet, dass** beim Schalten kein zusätzlicher Schaltkontakt benötigt wird.

## Claims

1. Circuit for transmitting a signal (I_{S}) in an uninterrupted manner which has a first current path (Sₚ) and a second current path (S_{d}) connected in parallel, and in which the first current path (Sₚ) contains at least one active component (A₁, A₂) and in which the second current path (S_{d}) has a component (D) which is passive at least some of the time and can be reversibly inserted, **characterised in that** the circuit and at least the active component (A₁, A₂) are dimensioned in such a way that the first current path (Sₚ) is connected in a d.c. voltage-controlled manner by means of the active component (A₁, A₂) when the second current path (S_{d}) does not contain the passive component (D), and **in that** the first current path (Sₚ) is disconnected in a d.c. voltage-controlled manner by means of the active component (A₁, A₂) when the second current path (Sₚ) contains the passive component (D), a control current which is superimposed as direct current (I_{G}) on the signal (I_{S}) being provided to switch the active component (A₁, A₂).

2. Circuit according to claim 1, **characterised in that** the passive component (D) is a fixed-value passive attenuator.

3. Circuit according to either of the preceding claims, **characterised in that** the attenuator (D) has three contacts containing an input (E), an output (A) and at least one shunt component which leads to earth (M) via a decoupling circuit (E₃).

4. Circuit according to any one of the preceding claims, **characterised in that** JXP or SXP attenuators are used as attenuators (D).

5. Circuit according to claim 1, **characterised in that** the attenuator (D) comprises a fixed-value three-pole passive attenuator (D), and **in that** signals are transmitted in a d.c. voltage-controlled and uninterrupted manner via the first current path (Sₚ) when the fixed-value three-pole attenuator is removed.

6. Circuit according to any one of the preceding claims, **characterised in that** the attenuator (D) is a PI-pad or a T-pad.

7. Circuit according to any one of the preceding claims, **characterised in that** the attenuator (D) is a component for adjusting the voltage, power or current level or for adjusting the frequency response of any electrical signal.

8. Circuit according to any one of the preceding claims, **characterised in that** it is suitable for (high-frequency) signal transmission.

9. Circuit according to any one of the preceding claims, **characterised in that** the direct current (I_{G}) superimposed in the circuit is coupled by a circuit (E_{E}) and is decoupled by a further circuit (E_{A}).

10. Circuit according to any one of the preceding claims, **characterised in that** the direct current (I_{G}) is coupled in the active component (A₁) and/or a further active component (A₂) in the first current path (Sp).

11. Circuit according to any one of the preceding claims, **characterised in that** passive components (Zₚ) are connected downstream of the at least one active component (A₁) in the first current path (Sp).

12. Circuit according to claim 1, **characterised in that** the passive components (Zₚ) in the first current path (Sₚ) cause defined attenuation with respect to signal transmission.

13. Circuit according to any one of the preceding claims, **characterised in that** it may be constructed so as to be suitable for wave impedance.

14. Circuit according to any one of the preceding claims, **characterised in that** the circuit is used in devices which form part of an FSN (full service network).

15. Circuit according to claim 14, **characterised in that** the devices of the full service network are distributors or taps or combining networks or amplifiers for audio or video or telecommunications transmissions, such as CATV or ADSL systems.

16. Circuit according to any one of the preceding claims, **characterised in that** it is suitable for both electrical signal transmission and optical signal transmission in electrical/optical interfaces.

17. Method for adjusting the attenuation of circuits containing fixed-value three-pole attenuators (D), in which the attenuator (D) is removed from a second current path (S_{d}) some of the time, and in which a signal (I_{S}) is transmitted in an uninterrupted and d.c. voltage-controlled manner via a first current path (Sₚ) owing to the removal of the attenuator (D), **characterised in that** the direct current (I_{G}) required for the d.c. voltage control is superimposed on the signal (I_{S}) when said signal enters the second current path (S_{d}).

18. Method according to claim 17, **characterised in that** the first current path (Sₚ) causes defined attenuation of the transmitted signal (I_{S}) when the passive attenuator (D) is removed from the second current path (S_{d}).

19. Method according to either claim 17 or claim 18, **characterised in that** the signal transmission is suitable for wave impedance.

20. Use of fixed-value three-pole attenuators as electrical signal path changeover switches in a circuit according to any one of claims 13 to 16.

21. Use of fixed-value three-pole attenuators as mechanical signal path changeover switches in a circuit according to any one of claims 13 to 16.

22. Use according to either claim 20 or claim 21, **characterised in that** fixed-value three-pole attenuators are used to switch from one current path to another current path.

23. Use according to claim 22, **characterised in that** the current path is switched by using at least one active component in one of the two current paths.

24. Use according to either claim 20 or claim 22, **characterised in that** no additional switching contact is required for switching.

## Revendications

1. Circuit pour la transmission de signaux sans interruption d'un signal (I_{S}) qui présente un premier trajet du courant (Sₚ) et un deuxième trajet du courant (S_{d}) qui sont montés en parallèle, dans lequel le premier trajet du courant (Sₚ) comprend au moins un composant actif (A₁, A₂), et dans lequel le deuxième trajet du courant (S_{d}) comprend au moins par intermittence une composante passive (D) qui peut être enfichée de façon réversible, **caractérisé en ce que** le circuit et au moins un composant actif (A₁, A₂) au nombre de un sont dimensionnés de sorte qu'une connexion, commandée par une tension continue, du premier trajet du courant (Sₚ) au moyen du composant actif (A₁, A₂) est prévue quand le deuxième trajet du courant (S_{d}) ne contient pas la composante passive (D), et **en ce qu'**une déconnexion, commandée par une tension continue, du premier trajet du courant (Sₚ) au moyen du composant actif (A₁, A₂) est prévue quand le deuxième trajet du courant (S_{d}) contient la composante passive (D), un courant de commande étant prévu pour le couplage du composant actif (A₁, A₂), courant de commande qui se superpose au signal (I_{S}) en tant que courant continu (I_{G}).

2. Circuit selon la revendication 1, **caractérisé en ce que** la composante passive (D) est un atténuateur passif ayant des valeurs fixes.

3. Circuit selon l'une des revendications précédentes, **caractérisé en ce que** l'atténuateur (D) possède 3 contacts qui contiennent une entrée (E), une sortie (A) et au moins un élément transversal qui est conduit à la masse (M) par le biais d'un circuit de découplage (E₃).

4. Circuit selon l'une des revendications précédentes, **caractérisé en ce que**, en tant qu'atténuateurs (D), on utilise des Attenuators JXP ou SXP.

5. Circuit selon la revendication 1, **caractérisé en ce que** l'atténuateur (D) comprend un atténuateur passif à 3 pôles ayant des valeurs fixes (D), et **en ce que**, lors de l'enlèvement de l'atténuateur à 3 pôles ayant des valeurs fixes, la transmission de signaux est commandée par une tension continue sans interruption via le premier trajet du courant (Sp).

6. Circuit selon l'une des revendications précédentes, **caractérisé en ce que** l'atténuateur (D) est un élément π ou un élément T.

7. Circuit selon l'une des revendications précédentes, **caractérisé en ce que** l'atténuateur (D) est une composante de réglage du niveau de tension, de puissance ou d'intensité ou de réglage de la réponse fréquentielle d'un signal électrique quelconque.

8. Circuit selon l'une des revendications précédentes, **caractérisé en ce qu'**il est approprié pour la transmission de signaux (à hautes fréquences).

9. Circuit selon l'une des revendications précédentes, **caractérisé en ce que** le courant continu (I_{G}) superposé dans le circuit est couplé par un câblage (E_{E}) et est découplé par un autre câble (E_{A}).

10. Circuit selon l'une des revendications précédentes, **caractérisé en ce que** le courant continu (I_{G}) est couplé dans une composante active (A₁) et/ou dans une autre composante active (A₂) du premier trajet du courant (Sp).

11. Circuit selon l'une des revendications précédentes, **caractérisé en ce que** des composantes passives (Zₚ) sont montées dans le premier trajet du courant (Sₚ) derrière la composante active (A₁) au moins au nombre de un.

12. Circuit selon la revendication 1, **caractérisé en ce que** les composantes passives (Zₚ) provoquent une atténuation définie dans le premier trajet du courant (Sₚ) en ce qui concerne la transmission de signaux.

13. Circuit selon l'une des revendications précédentes, **caractérisé en ce qu'**il peut être structuré de façon compatible avec l'impédance caractéristique.

14. Circuit selon l'une des revendications précédentes, **caractérisé en ce que** le circuit est monté dans des appareils qui font partie d'un FSN (Full Service Network).

15. Circuit selon la revendication 14, **caractérisé en ce que** les appareils du Full Service Network sont des répartiteurs ou des dérivateurs ou des réseaux de jonction ou des amplificateurs pour la transmission audio ou vidéo ou pour la transmission de télécommunications, par exemple des installations CATV ou ADSL.

16. Circuit selon l'une des revendications précédentes, **caractérisé en ce qu'**il est approprié aussi bien pour la transmission électrique de signaux que dans des interfaces électro/optiques d'une transmission optique de signaux.

17. Procédé de réglage de l'atténuation de circuits avec des atténuateurs (D) à 3 pôles ayant des valeurs fixes, dans lequel l'atténuateur (D) est enlevé par intermittence d'un deuxième trajet du courant (S_{d}), et dans lequel l'enlèvement de l'atténuateur (D) transmet un signal (I_{S}) sans interruption, de façon commandée par une tension continue, via un premier trajet du courant (Sₚ), **caractérisé en ce que** le courant continu (I_{G}) nécessaire pour la commande par tension continue est superposé au signal (I_{S}) quand il s'écoule dans le deuxième trajet du courant (S_{d}).

18. Procédé selon la revendication 17, **caractérisé en ce que** le premier trajet du courant (Sₚ) provoque une atténuation définie du signal (I_{S}) transmis quand l'atténuateur (D) passif est enlevé du deuxième trajet du courant (S_{d}).

19. Procédé selon l'une des revendications 17 à 18, **caractérisé en ce que** la transmission des signaux est effectuée de façon compatible avec l'impédance caractéristique.

20. Utilisation d'atténuateurs à 3 pôles ayant des valeurs fixes en tant que commutateur électrique de trajets de signaux dans un circuit selon l'une des revendications 13 à 16.

21. Utilisation d'atténuateurs à 3 pôles ayant des valeurs fixes en tant que commutateur mécanique de trajets de signaux dans un circuit selon l'une des revendications 13 à 16.

22. Utilisation selon l'une des revendications 20 ou 21, **caractérisée en ce que** les atténuateurs à 3 pôles ayant des valeurs fixes sont utilisés pour commuter un trajet du courant vers un autre trajet du courant.

23. Utilisation selon la revendication 22, **caractérisée en ce que** la commutation de trajet du courant est réalisée par l'utilisation d'au moins une composante active dans un des deux trajets du courant.

24. Utilisation selon l'une des revendications 20 ou 22, **caractérisée en ce que**, lors du couplage, aucun contact de commande supplémentaire n'est nécessaire.
